# EUROPEAN PATENT APPLICATION

(11) **EP 4 458 494 A1**
(43) Date of publication of application: **06.11.2024**
(21) Application number: 23171307.4
(22) Date of filing: 03.05.2023
(51) Int. Cl.: B22F 7/08, B22F 1/054, B22F 1/16, B22F 7/06, B81C 1/00, B81C 3/00, B22F 1/102, H01L 23/00

(54) **METHOD FOR CONNECTING COMPONENTS TO EACH OTHER**

(71) Applicant: NanoWired GmbH, 64579 Gernsheim (DE)
(72) Inventor: TREFILOV, Denis, 64579 Gernsheim (DE); WEISSENBORN, Florian, 64579 Gernsheim (DE); BIRLEM, Olav, 64579 Gernsheim (DE); QUEDNAU, Sebastian, 64579 Gernsheim (DE)
(74) Representative: Schwenderling, Jens

(57) **Abstract**

Method for connecting a first component (1) and a second component (2) to each other, comprising the following steps:
a) providing a plurality of nanowires (3) on a contact surface (4) of the first component (1), wherein the nanowires (3) have a coating (6) that comprises a reducing substance,
b) joining the first component (1) and the second component (2) such that the nanowires (3) on the contact surface (4) of the first component (1) come into contact with a contact surface (5) of the second component (2),
c) heating at least the nanowires (3) and the contact surface (5) of the second component (2) to a temperature of at least 150 °C.

## Description

The invention is directed to a method for connecting a first component and a second component to each other. Further, the invention is directed to a component configured for being used in the method. The invention can be applied in particular in order to connect electronic components to each other.

It is known to connect two components to each other using a plurality of nanowires. In particular, it is known to do so by providing a plurality of nanowires on a contact surface of a first of the components, but not on a contact surface of a second of the components, to join the components such that the nanowires come into contact with the contact surface of the second component and to heat the components with the nanowires.

The connection between the nanowires and the second component can be impaired by oxides or other substances on the surface of the nanowires. For example, if copper nanowires are used, a layer of copper oxide may form on the surface of the nanowires when the nanowires are exposed to air. If the contact surface of the second component is made of copper, a layer of copper oxide may also form on the contact surface of the second component. Similar problems occur with various other materials.

It is thus known from the prior art to treat the nanowires and the contact surface of the second component with a reducing substance prior to establishing the connection. However, this represents an additional method step, which is unfavorable. Also, this step requires a chemical substance to be used, which may in particular be liquid or gaseous. Liquid chemicals are generally undesired in production environments. Moreover, liquids can leave residues behind on the treated component. The use of gaseous chemicals requires the creation of a corresponding atmosphere, which can be difficult.

Further, suitable reducing substances tend to dry quickly, such that the components have to be connected to each other quickly once the reducing substance has been applied. It is thus difficult or even impossible to package and ship components after the reducing substance has been applied, since evaporation of the reducing substance has to be avoided. Also, evaporation of the reducing substance on the contact surface can cause the contact surface of the first component to cool, which can impair the connection between the components.

Some of these drawbacks are addressed in DE 10 2021 105 129. Therein, a method is described in which the oxide layer is removed from the nanowires. Subsequently, a protective coating is obtained using a protective substance. The protective substance prevents a new oxide layer from forming.

The teaching of DE 10 2021 105 129 is particularly useful in case nanowires are provided on both components. In that case, the components can be connected to each other without the need for any chemical substance during the actual joining step. Although it is also possible to apply the teaching of DE 10 2021 105 129 to the case where nanowires are only provided on one of the components, in that case the issue remains that a chemical treatment of the contact surface of the second component might be required.

The object of the invention is to further simplify the connection of a first component and a second component to each other, in particular in view of the usage of chemical substances.

The object is solved with the method and the component according to the independent claims. Advantageous refinements are presented in the dependent claims. The features described in the claims and in the description can be combined with each other in any technologically reasonable manner.

According to the invention a method for connecting a first component and a second component to each other is presented. The method comprises the following steps:
a) providing a plurality of nanowires on a contact surface of the first component, wherein the nanowires have a coating that comprises a reducing substance,
b) joining the first component and the second component such that the nanowires on the contact surface of the first component come into contact with a contact surface of the second component,
c) heating at least the nanowires and the contact surface of the second component to a temperature of at least 150 °C.

The described method is used to connect two components to each other. The components can be any objects. In particular, the components can be electronic components. For example, the first component can be a circuit board and the second component can be an electronic component such as a resistor or transistor that is supposed to be connected to the circuit board. However, the described method is not limited to applications in the field of electronics.

With the described method, a particularly strong mechanical connection can be obtained. This is achieved in that the connection is established using a plurality of nanowires. Owing to the small size of the nanowires, a large number of nanowires can be used, such that a large contact area can be obtained. Depending on the materials used for the contact surfaces and the nanowires, the obtained connection can be electrically conductive and/or thermally conductive. However, it is in particular also possible to obtain an electrically insulating connection.

The nanowires preferably have a length in the range from 100 nm [nanometres] to 100 µm [micrometres], in particular in the range from 500 nm to 60 µm. The nanowires also preferably have a diameter in the range from 10 nm to 10 µm, in particular in the range from 30 nm to 2 µm. Here, the term diameter relates to a circular base area, a comparable definition of a diameter being applicable if the base area deviates from this. It is particularly preferred that all of the nanowires used have the same length and the same diameter.

The described method can be used for a wide variety of materials of the nanowires. Electrically conducting materials, in particular metals such as copper, silver, gold, nickel, tin and platinum, are preferred as the material of the nanowires. However, non-conducting materials are also preferred. Preferably, all of the nanowires are formed from the same material.

The two components are connected to each other via respective contact surfaces. The contact surface of the first component is that part of the surface of the first component that participates in the connection. The contact surface of the second component is that part of the surface of the second component that participates in the connection. The contact surfaces are defined in terms of the connection. It is not necessary, but possible, that the contact surfaces are distinguished from the remaining part of the surface of the respective component in addition to participating in the connection. That is, before the connection is established, the contact surfaces do not have to, but can be recognizable as such.

In step a) a plurality of nanowires is provided on the contact surface of the first component, wherein the nanowires have a coating that comprises a reducing substance.

The nanowires with the coating can be provided on the contact surface of the first component in that in a single step the nanowires with the coating are generated on the contact surface of the first component as part of the described method. Alternatively, the nanowires with the coating can be provided on the contact surface of the first component in that the nanowires are generated on the contact surface of the first component as part of the described method and in that subsequently the coating is generated on the nanowires as part of the described method. Alternatively, the nanowires with the coating can be provided on the contact surface of the first component in that the nanowires with the coating are generated outside the described method, for example by a supplier, and in that a respectively prepared first component is acquired as step a).

Irrespective of when the nanowires are provided on the contact surface of the first component, the nanowires can be provided by being grown galvanically on the component. In case the contact surface of the first component is electrically conductive, the nanowires can be grown onto the contact surface without any further treatment of the contact surface. In case the contact surface of the first component is not electrically conductive, the contact surface is preferably first treated such as to become electrically conductive, for example by applying an electrically conductive metallization. Thus, for example, a substrate that is not electrically conducting may have been coated with a thin layer of metal in order to grow the nanowires onto the thin layer of metal. However, the described method can be applied irrespectively of

The nanowires have a respective first end that is connected to the contact surface of the first component at least after step a). A second end of the nanowires is a free end that can be brought into contact with the contact surface of the second component. After step a), the nanowires are preferably arranged perpendicularly to the contact surface of the first component. This refers to the nanowire section immediately at the first end. That is, the nanowires can have a bent shape. After step b), the nanowires are preferably arranged perpendicularly to the contact surface of the second component. This refers to the nanowire section immediately at the second end.

At least after step a), the nanowires on the contact surface of the first component have a coating that comprises a reducing substance. The coating has multiple purposes as will be described in the following.

The first purpose of the coating is apparent already immediately in view of step a). Since the coating comprises a reducing substance, a potential oxide layer of the surface of the nanowires can be removed. Once the nanowires come into contact with the reducing substance, an oxide layer on the nanowires can react with the reducing substance. This can remove the oxide layer and can form the coating as a protective layer on the nanowire surface.

Hence, the second purpose of the coating is also apparent immediately in view of step a). Since the coating separates the nanowire material from the environmental air, the coating prevents a new oxide layer from forming on the nanowire surfaces.

In the above described prior art teaching DE 10 2021 105 129 a reducing substance and a coating are used, too. Therein, however, the coating does not comprise the reducing substance. Instead, with the reducing substance and a protective substance as two different substances are used in two separate steps. To this end, the method described herein is simplified compared to the teaching of DE 10 2021 105 129.

The coating can be dry. That is, the first component can be stored, packaged and transported easily. The reducing substance is thus unlikely to evaporate before the connection is established, which avoids drawbacks of the prior art teaching. In particular, there are no residues that remain on the contact surfaces and the temperature of the contact surface does not fall due to evaporation of the reducing substance.

Preferably, the second component is provided in step a), preferably without nanowires on the second contact surface. That is, the connection between the two components is established with nanowires on one contact surface only. However, the described method can be performed as well with nanowires on the contact surfaces of both components.

In step b) the first component and the second component are joined such that the nanowires on the contact surface of the first component come into contact with a contact surface of the second component. The fact that the two components are joined means that the first component and the second component are moved towards each other such that the described contact between the nanowires and the contact surface of the second component is established. Therein, a pressure can be, but does not have to be applied.

With the nanowires contacting the contact surface of the second component, the first component and the second component can already be connected to each other. However, this is not necessarily the case. In any case, the obtained connection may be weak. In order to obtain a strong connection, in step c) at least the nanowires and the contact surface of the second component are heated to a temperature of at least 150°C, preferably of at least 180°C, more preferably of at least 200 °C. A maximum temperature of the heating is preferably 250 °C. With the heating a strong connection can be obtained between the free ends of the nanowires and the contact surface of the second component. After the heating, the nanowires no longer have to be distinguishable from each other.

In step c) it is sufficient that the nanowires and the contact surface of the second component are heated to the described temperature. This is sufficient in view of establishing the desired connection between the nanowires and the contact surface of the second component. However, this does not mean that the first component and other parts of the second component must not be heated. In fact, it is even preferred to heat the first component, the nanowires and the second components together, for example by placing these elements jointly into a furnace.

In step c) a third purpose of the coating becomes apparent. Since the coating comprises the reducing substance, a reducing atmosphere can be obtained when the coating evaporates at least in part due to the heating in step c). The reducing atmosphere acts onto the contact surface of the second component and can remove a potential oxide layer therefrom.

Thus, the coating that comprises the reducing substance is advantageous in multiple ways. In particular, it is sufficient to treat the first component with chemicals. This includes the chemicals used for growing the nanowires and for obtaining the coating on the nanowires. In fact, chemicals only have to be handled in step a). This step, however, can be performed with the first component only. The second component does not have to be treated with any chemicals at any time of the described method. It is sufficient to join the first component as prepared according to step a) to the second component and to perform the heating. The reducing atmosphere that acts onto the contact surface of the second component is generated by the coating on the nanowires. To this end, the first component brings everything that is required in order to obtain a strong connection. The second component does not require special treatment.

In a preferred embodiment of the method, step a) comprises the following sub-steps:
a1) growing the plurality of nanowires onto the contact surface of the first component,
a2) applying the coating that comprises the reducing substance to the nanowires grown in sub-step a1).

In the present embodiment the nanowires are obtained as part of the described method. To this end, the nanowires are grown in step a 1). This can be done by galvanically growing the nanowires onto the contact surface of the first component. In step a1), the nanowires are preferably grown onto the contact surface of the first component, but not onto the contact surface of the second component.

In sub-step a2) the coating is applied to the nanowires.

In a further preferred embodiment of the method in sub-step a2) the nanowires grown in sub-step a1) are subjected to a liquid that comprises the reducing substance.

The liquid can be a mixture or solution that comprises the reducing substance and further substances such as water or a different solvent. Preferably, the liquid comprises the reducing substance and a volatile substance. After such a liquid has been applied to the nanowires, the volatile substance evaporates, leaving the reducing substance as a coating on the nanowire surface.

The liquid can be applied to the nanowires in that the liquid is sprayed onto the nanowires and/or in that the nanowires are dipped into the liquid.

In a further preferred embodiment of the method the liquid is a mixture of ascorbic acid as the reducing substance and ethylene glycol.

It has been found that a mixture of ascorbic acid and ethylene glycol as the liquid provides particularly good results.

Alternatively, the liquid can be any of polyethylene glycol, glycerol, alcohol, water, terpineol, propylene glycol, decanol, pentanediol, CELTOL-IA, decanol or butanol.

In a further preferred embodiment of the method in sub-step a2) the liquid is dried after having been applied to the nanowires so as to obtain the coating.

The drying can be a vacuum drying.

In a further preferred embodiment of the method in step c) the reducing substance generates a reducing atmosphere.

The reducing atmosphere acts upon the contact surface of the second component. To this end, the first component brings everything needed to establish the connection. It is not necessary to treat the contact surface of the second component separately with a chemical substance.

In a further preferred embodiment of the method the reducing substance is an acid. Most preferably, the reducing substance is ascorbic acid.

The reducing substance can be any of ascorbic acid, oxalic acid, malonic acid, succinic acid, citric acid, formic acid, hydrazine or oleic acid.

In a further preferred embodiment of the method the nanowires are made of a material that comprises copper.

Copper is particularly suitable in many electronics applications, since copper is a particularly good electrical and thermal conductor. Also, copper is cheaper than metals such as gold. However, copper tends to form a layer of copper oxide on its surface, which can impair the quality of a connection. With the described method, the copper oxide layer can be removed.

However, the described method can alternatively be used with nanowires made of a variety of materials.

As a further aspect of the invention a component is presented that has a contact surface and a plurality of nanowires on the contact surface, wherein the nanowires have a coating that comprises a reducing substance.

The advantages and features of the method are transferrable to the component, and vice versa. The component is preferably configured to be used as the first component in the method. The method is preferably performed using the component as the first component.

In a preferred embodiment of the component the coating of the nanowires generates a reducing atmosphere at least when being heated to a temperature of more than 200 °C.

The fact that the coating of the nanowires generates a reducing atmosphere at least when being heated to a temperature of more than 200 °C is a property of the coating. This property merely requires that at a temperature of 200 °C or more the coating of the nanowires generates a reducing atmosphere. It is possible and preferred that the reducing atmosphere is generated already at lower temperatures. In particular, it is preferred that the coating of the nanowires generates a reducing atmosphere at least when being heated to a temperature of more than 180 °C, in particular of more than 150 °C.

To this end, the present embodiment is in line with step c) of the above described method, according to which the nanowires and the contact surface of the second component are heated to a temperature of at least 150 °C, which preferably already leads to the reducing atmosphere. However, it is preferred in step c) to heat the nanowires and the contact surface of the second component to a temperature of at least 180 °C or even to a temperature of more than 200 °C.

In any case it is preferred to heat the nanowires and the contact surface of the second component in step c) to a temperature that is only slightly above the temperature at which the coating generates a reducing atmosphere. Thereby, the effect of having a reducing atmosphere is achieved, while the components are subjected to high temperatures as little as necessary. Even if the heating in step c) is insufficient to actually achieve a reducing atmosphere can the components be connected to each other as described. Merely the additional benefit of having the contact surface of the second component be reduced is not achieved in that case.

In choosing the temperature for the heating, however, it should be kept in mind that the heating also has the purpose of establishing a strong connection between the nanowires and the contact surface of the second component.

In the following the invention will be described with respect to the figures. The figures show a preferred embodiment, to which the invention is not limited. The figures and the dimensions shown therein are only schematic. The figures show:
- Fig. 1:: a component according to the invention,
- Fig. 2:: the component of Fig. 1 after having been connected to a second component by a method according to the invention.

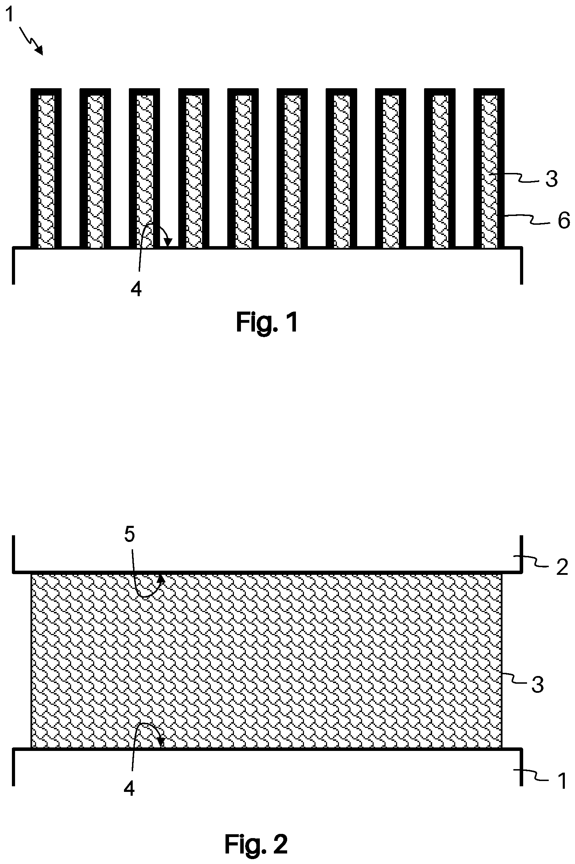

Fig. 1 shows a component 1 having a contact surface 4 and a plurality of nanowires 3 on the contact surface 4. The nanowires 3 have a coating 6 that comprises a reducing substance. The coating 6 of the nanowires 3 generates a reducing atmosphere when being heated to a temperature of more than 180 °C. The nanowires 3 are made of a material that comprises copper.

Fig. 2 shows the component 1 of Fig. 1 after having been connected to a second component 2. In order to distinguish the components 1,2, the component 1 shown in Fig. 1 is labeled first component 1.

The first component 1 and the second component 2 can be connected to each other using a method that comprises the following steps:
a1) growing the plurality of nanowires 3 onto the contact surface 4 of the first component 1,
a2) applying the coating 6 that comprises the reducing substance to the nanowires 3 grown in sub-step a1) by subjecting the nanowires 3 grown in sub-step a1) to a liquid that is a mixture of ascorbic acid as the reducing substance and ethylene glycol and by drying the liquid after having been applied to the nanowires 3,
b) joining the first component 1 and the second component 2 such that the nanowires 3 on the contact surface 4 of the first component 1 come into contact with a contact surface 5 of the second component 2,
c) heating the first component 1 and the second component 2 to a temperature of 180 °C, such that the reducing substance generates a reducing atmosphere.

### List of reference numerals

- 1: first component
- 2: second component
- 3: nanowires
- 4: contact surface of the first component
- 5: contact surface of the second component
- 6: coating

## Claims

1. Method for connecting a first component (1) and a second component (2) to each other, comprising the following steps:
a) providing a plurality of nanowires (3) on a contact surface (4) of the first component (1), wherein the nanowires (3) have a coating (6) that comprises a reducing substance,
b) joining the first component (1) and the second component (2) such that the nanowires (3) on the contact surface (4) of the first component (1) come into contact with a contact surface (5) of the second component (2),
c) heating at least the nanowires (3) and the contact surface (5) of the second component (2) to a temperature of at least 150 °C.

2. Method according to claim 1, wherein step a) comprises the following sub-steps:
a1) growing the plurality of nanowires (3) onto the contact surface (4) of the first component (1),
a2) applying the coating (6) that comprises the reducing substance to the nanowires (3) grown in sub-step a1).

3. Method according to claim 2, wherein in sub-step a2) the nanowires (3) grown in sub-step a1) are subjected to a liquid that comprises the reducing substance.

4. Method according to claim 3, wherein the liquid is a mixture of ascorbic acid as the reducing substance and ethylene glycol.

5. Method according to claim 3 or 4, wherein in sub-step a2) the liquid is dried after having been applied to the nanowires (3) so as to obtain the coating (6).

6. Method according to any of the preceding claims, wherein in step c) the reducing substance generates a reducing atmosphere.

7. Method according to any of the preceding claims, wherein the reducing substance is an acid.

8. Method according to any of the preceding claims, wherein the nanowires (3) are made of a material that comprises copper.

9. Component (1) having a contact surface (4) and a plurality of nanowires (3) on the contact surface (4), wherein the nanowires (3) have a coating (6) that comprises a reducing substance.

10. Component (1) according to claim 9, wherein the coating (6) of the nanowires (3) generates a reducing atmosphere at least when being heated to a temperature of more than 200 °C.
